# EUROPÄISCHE PATENTANMELDUNG

(11) **EP 3 493 274 A1**
(43) Veröffentlichungstag der Anmeldung: **05.06.2019**
(21) Anmeldenummer: 17205274.8
(22) Anmeldetag: 04.12.2017
(51) Int. Cl.: H01L 31/0749, H01L 31/046, H01L 31/0465

(54) **DÜNNSCHICHTSOLARMODUL MIT VERBESSERTEM SHUNT-WIDERSTAND**

(71) Anmelder: Bengbu Design & Research Institute for Glass Industry, Bengbu, Anhui 233010 (CN)
(72) Erfinder: VERMA, Rajneesh, 81243 München (DE); SCHUBBERT, Christian, 81735 München (DE); STÖLZEL, Marko, 81827 München (DE)
(74) Vertreter: Gebauer, Dieter Edmund

(57) **Zusammenfassung**

Die Erfindung betrifft ein Dünnschichtsolarmodul mit einem Substrat und einem darauf aufgebrachten Schichtenaufbau, der eine Rückelektrodenschicht, eine Frontelektrodenschicht und eine zwischen Rück- und Frontelektrodenschicht angeordnete Absorberschicht umfasst, wobei die Absorberschicht eine Dotierung von einem ersten Leitungstyp und die Frontelektrodenschicht eine Dotierung vom zweiten Leitungstyp aufweist, wobei im Schichtenaufbau durch Strukturierungszonen serienverschaltete Solarzellen ausgebildet sind, wobei mindestens eine Strukturierungszone aufweist:
- einen mindestens die Rückelektrodenschicht unterteilenden ersten Strukturierungsgraben (P1),
- einen mindestens die Absorberschicht unterteilenden zweiten Strukturierungsgraben (P2),
- einen mindestens die Frontelektrodenschicht (8) unterteilenden dritten Strukturierungsgraben (P3),
wobei der erste Strukturierungsgraben (P1) durch Material der Absorberschicht verfüllt ist, und wobei innerhalb des ersten Strukturierungsgrabens mindestens ein Isolationsgraben ausgebildet ist, der durch mindestens ein Material verfüllt ist, das eine kleinere elektrische Leitfähigkeit für Ladungsträger vom ersten Leitungstyp aufweist als die Absorberschicht.

## Beschreibung

Die vorliegende Erfindung liegt auf dem technischen Gebiet der photovoltaischen Energieerzeugung und betrifft ein Dünnschichtsolarmodul mit einem verbesserten Shunt-Widerstand, sowie ein Verfahren zu dessen Herstellung.

In der Patentliteratur wurden Dünnschichtsolarmodule bereits vielfach beschrieben. Lediglich beispielhaft sei auf die Druckschriften DE 4324318 C1 und EP 2200097 A1 verwiesen. Dünnschichtsolarmodule bieten den besonderen Vorteil, dass die Solarzellen schon während der Schichtenherstellung in integrierter Form seriell verschaltet werden können. Die verschiedenen Schichten werden typischer Weise direkt auf ein Trägersubstrat aufgebracht, das nach Strukturierung der Solarzellen mit einer Deckschicht versehen wird, wodurch ein bewitterungsstabiler Verbund erhalten wird. Der Schichtenaufbau umfasst eine Frontelektrodenschicht, eine Rückelektrodenschicht sowie eine photovoltaisch aktive Absorberschicht, wobei in aller Regel weitere Schichten vorhanden sind.

Hinsichtlich der technologischen Handhabbarkeit und des Wirkungsgrads haben sich Dünnschichtsolarmodule mit einer Absorberschicht aus amorphem, mikromorphem oder polykristallinem Silizium, Cadmium-Tellurid (CdTe), Gallium-Arsenid (GaAs) oder einer Chalkopyrit-Verbindung, insbesondere Kupfer-Indium/Gallium-Disulfid/Diselenid
(Cu(In,Ga)S,Se)₂), als vorteilhaft erwiesen. Aufgrund des an das Spektrum des Sonnenlichts gut angepassten Bandabstands können mit Verbindungen auf der Basis von Cu(In,Ga)(S,Se)₂ besonders hohe Absorptionskoeffizienten erreicht werden.

Bei der Herstellung von Dünnschichtsolarmodulen können verschiedenartige Defekte auftreten, welche in nachteiliger Weise interne elektrische Leistungsverluste bewirken und die Nennleistung und den Wirkungsgrad des Moduls vermindern. Die Güte eines Dünnschichtsolarmoduls kann durch den so genannten Füllfaktor beschrieben werden. Hierbei handelt es sich um eine Maßzahl, die sich aus dem Quotienten aus der maximalen Leistung des Solarmoduls und dem Produkt aus Kurzschlußstrom und Leerlaufspannung ergibt. Je niedriger der Füllfaktor, desto niedriger ist der Wirkungsgrad des Solarmoduls, so dass ein möglichst höher Füllfaktor wünschenswert ist.

Ein wichtiges Beispiel für einen leistungsvermindernden Defekt sind elektrische Kurzschlüsse (Shunts), die zu einer erhöhten Rekombinationsrate von Ladungsträgern führen und den Füllfaktor von Solarmodulen in unerwünschter Weise reduzieren. Shunts können vielfältige Ursachen haben. Häufig basieren sie auf herstellungsbedingten Defekten bei der Formung der integrierten Serienverschaltung der Solarzellen, wobei es insbesondere bei der Fertigung der Strukturierungslinien zur Serienverschaltung der Solarzellen zu unbeabsichtigten elektrischen Kontakten zwischen Front- und Rückelektrode der Solarzellen kommt.

Demgegenüber besteht die Aufgabe der vorliegenden Erfindung darin, im Stand der Technik bekannte Dünnschichtsolarmodule sowie deren Herstellung in vorteilhafter Weise so weiterzubilden, dass der Wirkungsgrad des Dünnschichtsolarmoduls erhöht ist. Zudem sollen die Module in der industriellen Serienfertigung auch mit gängigen Verfahren kostengünstig und effizient herstellbar sein.

Diese und weitere Aufgaben werden nach dem Vorschlag der Erfindung durch ein Dünnschichtsolarmodul sowie ein Verfahren zu dessen Herstellung gemäß den nebengeordneten Patentansprüchen gelöst. Vorteilhafte Ausgestaltungen der Erfindung sind durch die Merkmale der Unteransprüche angegeben.

Erfindungsgemäß ist ein Dünnschichtsolarmodul gezeigt, das ein Substrat mit einem darauf aufgebrachten Schichtenaufbau mit einer monolithisch integrierten Serienverschaltung von Solarzellen zur photovoltaischen Energieerzeugung umfasst.

In Einklang mit der üblichen Verwendung des Begriffs "Dünnschichtsolarmodul" bezieht er sich auf Module mit einem Schichtenaufbau mit einer geringen Dicke von beispielsweise einigen Mikrometern, so dass ein Trägersubstrat für eine ausreichende mechanische Festigkeit benötigt wird. Das Trägersubstrat kann beispielsweise aus anorganischem Glas, Kunststoff oder Metall, aber auch aus einer Metallegierung, bestehen und kann in Abhängigkeit von der jeweiligen Schichtdicke und den spezifischen Materialeigenschaften als starre Platte oder biegsame Folie ausgestaltet sein.

Die Erfindung bezieht sich auf ein Dünnschichtsolarmodul in Substratkonfiguration, bei der der Schichtenaufbau zur Herstellung der Solarzellen auf einer der Lichteintrittsseite zugewandten Oberfläche eines Substrats aufgebracht ist. Die Erfindung bezieht sich gleichermaßen auf ein Dünnschichtsolarmodul in Superstratkonfiguration, bei welcher das Substrat transparent und der Schichtenaufbau auf einer von der Lichteintrittsseite abgewandten Oberfläche des Substrats aufgebracht ist.

In an sich bekannter Weise umfasst der Schichtenaufbau eine Rückelektrodenschicht, eine Frontelektrodenschicht, und eine zwischen Rückelektroden- und Frontelektrodenschicht angeordnete, photovoltaisch aktive Absorberschicht.

Die Frontelektrodenschicht ist optisch transparent, da ein Durchtritt von Licht zum Schichtenaufbau ermöglicht sein muss. Die transparente Frontelektrodenschicht umfasst typischer Weise ein dotiertes Metalloxid (TCO = Transparent Conductive Oxide), beispielsweise n-leitendes, insbesondere Aluminium-dotiertes, Zinkoxid (AZO).

Die photovoltaisch aktive Absorberschicht umfasst vorzugsweise eine Chalkopyrit-Verbindung, bei der es sich vorteilhaft um einen I-III-VI-Halbleiter aus der Gruppe Kupfer-Indium/Gallium-Disulfid/Diselenid (Cu(In,Ga)(S,Se)₂) handelt. In vorstehender Formel können Indium und Gallium entweder allein oder in Kombination vorliegen. Entsprechendes gilt für Schwefel und Selen, die entweder allein oder in Kombination vorliegen können. Als Material für die Absorberschicht eignet sich in besonderer Weise CIS (Kupferindiumdiselenid/-disulfid) oder CIGS (Kupferindiumgalliumdiselenid, Kupferindiumgalliumdisulfid, Kupferindiumgalliumdisulfoselenid).

Gemäß einer Ausgestaltung weist die Absorberschicht eine Dotierung von einem ersten Leitungstyp (Ladungsträgertyp) und die Frontelektrode eine Dotierung vom entgegengesetzten Leitungstyp (Ladungsträgertyp) auf. Typischer Weise ist die Absorberschicht p-leitend (p-dotiert), verfügt also über einen Überschuß von Defektelektronen (Löcher) und die Frontelektrodenschicht ist n-leitend (n-dotiert), so dass freie Elektronen in Überschuß vorhanden sind. Vorzugsweise umfasst oder besteht die Absorberschicht aus einem p-leitenden Chalkopyrit-Halbleiter. Besonders vorteilhaft umfasst oder besteht die Absorberschicht aus einem p-leitenden I-III-VI-Halbleiter aus der Gruppe Kupfer-Indium/Gallium-Disulfid/Diselenid (Cu(In,Ga)(S,Se)₂).

Zwischen der Absorberschicht und der Frontelektrodenschicht ist typischer Weise eine Pufferschicht angeordnet. Dies gilt insbesondere für Absorberschichten auf der Basis von Cu(In,Ga)(S,Se)₂, bei denen eine Pufferschicht zwischen einer p-leitenden Cu(In,Ga)(S,Se)₂-Absorberschicht und einer n-leitenden Frontelektrode benötigt wird. Nach derzeitiger Erkenntnis ermöglicht die Pufferschicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-Magnetron-Sputtern.

Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Dies hat zur Folge, dass sich in den Solarzellen jeweils eine Raumladungszone aufbaut, dessen elektrisches Feld bewirkt, dass die Elektronen der im Absorber photoaktiv erzeugten Elektron-Loch-Paare zur Frontelektrode und die Löcher zur Rükkelektrode driften.

Im Schichtenaufbau des Dünnschichtsolarmoduls sind in herkömmlicher Weise durch Strukturierungszonen die integriert serienverschalteten Solarzellen ausgebildet. So ist mindestens die Rückelektrodenschicht durch erste Strukturierungsgräben, üblicher Weise als "P1" bezeichnet, in voneinander getrennte Abschnitte unterteilt, welche die Rückelektroden der Solarzellen bilden. Ferner ist mindestens die Absorberschicht durch zweite Strukturierungsgräben, üblicher Weise als "P2" bezeichnet, in voneinander getrennte Abschnitte unterteilt, welche die Absorber der Solarzellen bilden, und mindestens die Frontelektrodenschicht ist durch dritte Strukturierungsgräben, üblicher Weise als "P3" bezeichnet, in voneinander getrennte Abschnitte unterteilt, welche die Frontelektroden der Solarzellen bilden. Benachbarte Solarzellen sind über elektrisch leitfähiges Material in den zweiten Strukturierungsgräben P2 in Serienverschaltung elektrisch miteinander verbunden, wobei die Frontelektrode einer Solarzelle mit der Rückelektrode der benachbarten Solarzelle elektrisch verbunden ist und diese typischer Weise, jedoch nicht zwingend, direkt kontaktiert. Die Strukturierungsgräben sind in der Reihenfolge P1-P2-P3 angeordnet, wobei durch eine unmittelbare Abfolge aus erstem bis drittem Strukturierungsgraben P1-P2-P3 eine Strukturierungszone im Sinne vorliegender Erfindung gebildet wird.

Im Sinne vorliegender Erfindung bezieht sich der Begriff "Graben" auf eine materialverfüllte längliche Vertiefung (senkrecht zum flächigen Substrat) des Schichtenaufbaus, wobei ein Graben in einer oder mehreren Schichten des Schichtenaufbaus ausgebildet ist. Der Begriff "Strukturierungsgraben" bezieht sich auf einen Graben, welcher der Strukturierung der integriert serienverschalteten Solarzellen dient, wobei ein Strukturierungsgraben mindestens eine Schicht in zwei voneinander getrennte Schichtabschnitte vollständig unterteilt. Jeder Strukturierungsgraben wird von zwei einander gegenüberliegenden Grabenwänden begrenzt, wobei wenigstens ein Abschnitt einer jeden Grabenwand vom Material der unterteilten Schicht gebildet ist. Ein Strukturierungsgraben ist mit Material verfüllt, das von dem Material der mindestens einen unterteilten Schicht verschieden ist. So sind in dem erfindungsgemäßen Dünnschichtsolarmodul insbesondere die ersten Strukturierungsgräben P1 zur Unterteilung der Rückelektrodenschicht in Rückelektroden der Solarzellen durch Material der Absorberschicht verfüllt. Dies kann in einfacher Weise während der Abscheidung der Absorberschicht erfolgen.

Vorzugsweise sind die Strukturierungszonen jeweils linienförmig, insbesondere geradlinig, ausgebildet. In entsprechender Weise sind die Strukturierungsgräben vorzugsweise linienförmig in Form von Strukturierungslinien, insbesondere geradlinigen Strukturierungslinien, ausgebildet. In den Strukturierungszonen sind der erste bis dritte Strukturierungsgraben P1-P2-P3 vorzugsweise parallel zueinander angeordnet und verlaufen beispielsweise parallel zu einem Rand eines rechteckigen oder quadratischen Moduls. Insbesondere können sich die Strukturierungsgräben P1-P2-P3 jeweils bis zum Rand des Schichtenaufbaus erstrecken. Die Erstreckungsrichtung der Strukturierungsgräben P1-P2-P3 kann als Modul- bzw. Solarzellenbreite, die hierzu senkrechte Richtung als Modul- bzw. Solarzellenlänge definiert werden.

In Einklang mit der gängigen Verwendung bezieht sich der Begriff "Solarzelle" auf einen Bereich des Schichtenaufbaus, der eine Frontelektrode, einen Absorber und eine Rükkelektrode aufweist und von zwei einander unmittelbar benachbarten Strukturierungszonen, jeweils bestehend aus den Strukturierungsgräben P1-P2-P3, begrenzt wird. Im Randbereich des Moduls gilt dies analog, wobei anstelle einer Strukturierungszone ein Anschlußabschnitt für eine elektrische Kontaktierung der Serienverschaltung der Solarzellen vorliegt, so dass die Solarzelle durch den Schichtenbereich mit Frontelektrode, Absorber und Rückelektrode definiert ist, der sich zwischen einer Strukturierungszone und dem unmittelbar angrenzenden Anschlußabschnitt befindet.

Gemäß vorliegender Erfindung ist innerhalb des ersten Strukturierungsgrabens P1 mindestens einer Strukturierungszone, vorzugsweise aller Strukturierungszonen, mindestens ein mit Material verfüllter Graben ausgebildet, im Weiteren zur leichteren Bezugnahme als "Isolationsgraben" bezeichnet. Der Isolationsgraben ist durch mindestens ein Material, welches vom Material der Absorberschicht verschieden ist, im Weiteren zur leichteren Bezugnahme als "Isolationsgrabenmaterial" bezeichnet, vollständig verfüllt. Wesentlich ist, dass das den Isolationsgraben verfüllende mindestens eine Material einen größeren elektrischen Widerstand (d.h. kleinere elektrische Leitfähigkeit) für Ladungsträger des ersten Leitungstyps (Überschuß-Ladungsträger der Absorberschicht) aufweist als die Absorberschicht selbst. Ist die Absorberschicht beispielsweise p-leitend, weist das Isolationsgrabenmaterial einen größeren elektrischen Widerstand für Löcher auf als das Material der Absorberschicht. Diese Bedingung für die elektrische Leitfähigkeit des Isolationsgrabenmaterials umfasst auch den Fall, dass das Isolationsgrabenmaterial eine zum Material der Absorberschicht gegensätzliche Dotierung aufweist. Für den Fall einer p-leitenden Dotierung der Absorberschicht kann das Isolationsgrabenmaterial eine n-leitende Dotierung aufweisen, wobei die elektrische Leitfähigkeit für Löcher stets geringer ist als jene der p-leitenden Absorberschicht.

Wie die Erfinder erstmals erkannt haben, können für den Füllfaktor des Dünnschichtsolarmoduls relevante Shunts nicht nur durch Fehler oder Mängel bei der Herstellung der Module sondern auch durch den grundsätzlichen Aufbau der integrierten Serienverschaltung bedingt sein. Dies ist insbesondere dann der Fall, wenn die ersten Strukturierungsgräben P1 zur Unterteilung der Rückelektrodenschicht in Rückelektroden der Solarzellen durch Material der Absorberschicht verfüllt werden. So weist beispielsweise der häufig als Absorber verwendete p-dotierte Chalkopyrit-Halbleiter zwar eine geringe, jedoch nicht-verschwindende elektrische Leitfähigkeit für Löcher auf, so dass ein permanenter elektrischer Kurzschluß (Shunt) zwischen zwei unmittelbar benachbarten Rückelektroden vorliegt, wodurch der Wirkungsgrad des Moduls verringert wird. Denkbar wäre, zur Vermeidung dieses Problems die ersten Strukturierungsgräben so breit zu machen, dass der elektrische Shunt-Widerstand für Löcher so hoch ist, dass die Problematik vernachlässigbar ist. Jedoch verringert diese Vorgehensweise die optisch aktive Fläche des Moduls, so dass in nachteiliger Weise der Wirkungsgrad des Moduls verringert ist.

Die Erfindung zeigt einen völlig neuen Weg zur Lösung dieses Problems auf, indem innerhalb des ersten Strukturierungsgrabens P1 mindestens einer Strukturierungszone mindestens ein Isolationsgraben ausgebildet ist, der mit mindestens einem Material verfüllt ist, das eine geringere elektrische Leitfähigkeit für die Überschuß-Ladungsträger der Absorberschicht (z.B. Löcher) aufweist als die Absorberschicht, so dass ein elektrischer Kurzschluß von Löchern zwischen unmittelbar angrenzenden Rückelektroden gehemmt oder vermieden wird. Der Shunt-Widerstand des ersten Strukturierungsgrabens P1 wird durch das Isolationsgrabenmaterial erhöht. Die optisch aktive Fläche des Dünnschichtsolarmoduls wird hierbei nicht beeinträchtigt. Der Füllfaktor und somit Wirkungsgrad des erfindungsgemäßen Dünnschichtsolarmoduls kann somit in vorteilhafter Weise vergrößert werden.

Mindestens ein Abschnitt des materialverfüllten Isolationsgrabens ist innerhalb des ersten Strukturierungsgrabens ist im dort befindlichen Material der Absorberschicht ausgebildet. Vorzugsweise ist der Isolationsgraben linienförmig (Isolationslinie), insbesondere geradlinig, ausgebildet und erstreckt sich besonders bevorzugt parallel zu dem ersten bis dritten Strukturierungsgraben P1-P2-P3. Insbesondere kann sich der Isolationsgraben bis zum Rand des Schichtenaufbaus erstrecken. Der Isolationsgraben erstreckt sich vorzugsweise, jedoch nicht zwingend, bis zum Boden des ersten Strukturierungsgrabens. Der Isolationsgraben stellt eine materialverfüllte Ausnehmung wenigstens innerhalb des ersten Strukturierungsgrabens dar.

Der mindestens eine Isolationsgraben des ersten Strukturierungsgrabens mindestens einer Strukturierungszone ist innerhalb des ersten Strukturierungsgrabens ausgebildet. Demzufolge ist eine als "Breite" des Isolationsgrabens bezeichnete Abmessung (innerhalb des ersten Strukturierungsgrabens) in Richtung der Abfolge des ersten, zweiten und dritten Strukturierungsgrabens der Strukturierungszone kleiner als eine in gleicher Richtung sich bemessende Breite des ersten Strukturierungsgrabens.

Vorzugsweise weist der Isolationsgraben des ersten Strukturierungsgrabens mindestens einer Strukturierungszone eine von der elektrischen Leitfähigkeit für Ladungsträger vom ersten Leitungstyp des Isolationsgrabenmaterials abhängige Mindestbreite auf, wodurch eine hinreichende Vergrößerung des elektrischen Widerstands für die Ladungsträger vom ersten Leitungstyp erreicht werden soll. Vorzugsweise weist der Isolationsgraben zu diesem Zweck eine solche Breite auf, dass der elektrische (Shunt-)Widerstand für Ladungsträger vom ersten Leitungstyp im ersten Strukturierungsgraben mindestens das 1,5-fache, mindestens das 2-fache, insbesondere das 1,5-fache bis 4-fache, des elektrischen (Shunt-)Widerstands für Ladungsträger vom ersten Leitungstyp im ersten Strukturierungsgrabens ohne Isolationsgraben beträgt. Betrachtet wird hierbei der elektrische Widerstand zwischen den beiden vom ersten Strukturierungsgraben getrennten Rückelektroden, also über die volle Breite des ersten Strukturierungsgrabens. Hierdurch kann in aller Regel eine zufriedenstellende Vergrößerung des Füllfaktors des Dünnschichtsolarmoduls erreicht werden.

Vorzugsweise beträgt die Breite des Isolationsgrabens des ersten Strukturierungsgrabens mindestens einer Strukturierungszone mindestens 10%, mindestens 20%, mindestens 30%, mindestens 40%, oder mindestens 50%, jedoch weniger als 100%, der Breite des ersten Strukturierungsgrabens. Hierdurch kann, abhängig vom Isolationsgrabenmaterial, eine deutliche Vergrößerung des elektrischen (Shunt-)Widerstands für Ladungsträger vom ersten Leitungstyp im ersten Strukturierungsgraben erzielt werden. Beispielsweise weist der Isolationsgraben bei einer Breite des ersten Strukturierungsgrabens von 40 µm eine minimale Breite von 5 µm auf und die Breite des Isolationsgrabens liegt vorteilhaft im Bereich von 5 µm bis 30 µm.

Der mindestens eine Isolationsgraben des ersten Strukturierungsgrabens mindestens einer Strukturierungszone kann gemäß einer Ausgestaltung der Erfindung vollständig innerhalb des den ersten Strukturierungsgraben verfüllenden Materials der Absorberschicht ausgebildet sein. Dies bedeutet, dass die beiden einander gegenüber liegenden Grabenwände des Isolationsgrabens, zwischen denen sich die Breite des Isolationsgrabens bemisst, durch Material der Absorptionsschicht gebildet sind. Vorzugsweise, jedoch nicht zwingend, wird das innerhalb des ersten Strukturierungsgrabens befindliche Material der Absorptionsschicht durch den Isolationsgraben in zwei voneinander getrennte Abschnitte vollständig unterteilt, wobei sich der Isolationsgraben in diesem Fall bis auf den Boden des ersten Strukturierungsgrabens erstreckt.

Gemäß einer alternativen Ausgestaltung ist der Isolationsgraben des ersten Strukturierungsgrabens mindestens einer Strukturierungszone an einem von einer Rückelektrode gebildeten Rand des ersten Strukturierungsgrabens angeordnet, wobei der Rand näher zum zweiten Strukturierungsgraben der Strukturierungszone angeordnet ist als ein von der anderen Rückelektrode gebildeter gegenüberliegender Rand des ersten Strukturierungsgrabens. Vorzugsweise, jedoch nicht zwingend, wird das innerhalb des ersten Strukturierungsgrabens befindliche Material der Absorptionsschicht durch den Isolationsgraben von der angrenzenden Rückelektrode vollständig getrennt, wobei sich der Isolationsgraben bis auf den Boden des ersten Strukturierungsgrabens erstreckt. In diesem Fall werden die Grabenwände des Isolationsgrabens von dem Material der Absorptionsschicht und der Rückelektrode gebildet.

Bei einer in fertigungstechnischer Hinsicht besonders vorteilhaften Ausgestaltung ist die Mitte einer Abmessung des Isolationsgrabens, bemessen in Richtung der Abfolge des ersten, zweiten und dritten Strukturierungsgrabens der Strukturierungszone, d.h. die Mitte der Breite des Isolationsgrabens, nicht in Übereinstimmung mit der Mitte einer Abmessung des ersten Strukturierungsgrabens, ebenfalls bemessen in Richtung der Abfolge des ersten, zweiten und dritten Strukturierungsgrabens der Strukturierungszone, d.h. die Mitte der Breite des ersten Strukturierungsgrabens. In diesem Fall ist die Mitte der Breite des Isolationsgrabens in Richtung des zweiten Strukturierungsgrabens derselben Strukturierungszone versetzt und befindet sich somit in jener Hälfte des ersten Strukturierungsgrabens, die näher zum zweiten Strukturierungsgraben derselben Strukturierungszone angeordnet ist, als die andere Hälfte des ersten Strukturierungsgrabens. Durch diese Maßnahme kann zuverlässig und sicher ein versehentlicher Berührungskontakt vermieden werden zwischen dem Material der Isolationsgrabens und der den ersten Strukturierungsgraben begrenzenden Rückelektrode, die weiter entfernt ist vom zweiten Strukturierungsgraben derselben Strukturierungszone als die andere den ersten Strukturierungsgraben begrenzende Rückelektrode. Abhängig vom Material zur Verfüllung des Isolationsgrabens (z.B. Material der Frontelektrodenschicht) könnte bei einem Berührungskontakt in unerwünschter Weise ein Kurzschluß zwischen Front- und Rückelektrode erzeugt werden.

Typischer Weise ist zwischen der Absorberschicht und der Frontelektrodenschicht eine Pufferschicht angeordnet. Gemäß einer vorteilhaften Ausgestaltung ist der Isolationsgraben des ersten Strukturierungsgrabens mindestens einer Strukturierungszone durch Material der Pufferschicht verfüllt. Dies ermöglicht eine besonders einfache Herstellung der mit Material verfüllten Isolationsgräben, da eine Verfüllung in einfacher Weise beim Abscheiden der Pufferschicht erfolgen kann. Das Material der Pufferschicht weist aufgrund seiner Aufgabe, eine elektronische Anpassung zwischen Absorber und Frontelektrode zu erreichen, stets eine geringere elektrische Leitfähigkeit für Ladungsträger des ersten Leitungstyps auf als die Absorberschicht selbst, so dass es gut geeignet ist, einen elektrischen Kurzschluß für Ladungsträger vom ersten Ladungstyp im ersten Strukturierungsgraben zwischen den einander unmittelbar benachbarten Rückelektroden zu vermeiden oder wenigstens zu hemmen. Es kann hierdurch eine gute Vergrößerung des elektrischen Widerstands für Ladungsträger vom ersten Ladungstyp innerhalb der ersten Strukturierungsgräben erreicht werden.

Vorzugsweise umfasst das Material der Pufferschicht eine oder mehrere Verbindungen, die gewählt sind aus der Gruppe, welche aus Indiumsulfid (InS), Natrium-dotiertes Indiumsulfid (InS:Na), Kadmiumsulfid (CdS), Zinkoxosulfid (ZnOS) und intrinsisches Zinkoxid (i-ZnO) besteht. Insbesondere kann die Pufferschicht aus einem oder mehreren dieser Materialien bestehen.

Gemäß einer weiteren Ausgestaltung der Erfindung ist der Isolationsgraben des ersten Strukturierungsgrabens mindestens einer Strukturierungszone, insbesondere aller Strukturierungszonen, mit einem Material verfüllt, das eine Dotierung vom zweiten Leitungstyp, d.h. eine Dotierung mit einem zum Leitungstyp der Absorberschicht gegensätzlichen Leitungstyp aufweist. Bei einer p-leitenden Absorberschicht weist das Isolationsgrabenmaterial eine n-Dotierung auf. Vorzugsweise ist der Isolationsgraben zu diesem Zweck mit dem Material der n-leitenden Frontelektrodenschicht verfüllt, wobei es beispielsweise um Aluminium-dotiertes Zinkoxid (ZnO:Al) handelt. Auch durch diese Maßnahme kann eine gute Vergrößerung des elektrischen (Shunt-)Widerstands für Ladungsträger vom ersten Leitungstyp innerhalb des ersten Strukturierungsgrabens erreicht werden. Zudem bieten sich verfahrenstechnische Vorteile, da die Verfüllung der Isolationsgräben gleichzeitig mit dem Verfüllen der zweiten Strukturierungsgräben durch Material der Frontelektrodenschicht erfolgen kann.

Des Weiteren erstreckt sich die Erfindung auf ein Verfahren zur Herstellung eines wie oben beschrieben ausgebildeten Dünnschichtsolarmoduls.

Das Verfahren umfasst das Bereitstellen eines Substrats und das Herstellen eines Schichtenaufbaus auf dem Substrat, wobei der Schichtenaufbau mit einer Rückelektrodenschicht, einer Frontelektrodenschicht und einer zwischen Rück- und Frontelektrodenschicht angeordneten Absorberschicht mit durch Strukturierungszonen serienverschalteten Solarzellen versehen ist. Hierbei ist mindestens ein Isolationsgraben innerhalb eines die Rückelektrodenschicht unterteilenden ersten Strukturierungsgrabens mindestens einer Strukturierungszone, insbesondere aller Strukturierungszonen, ausgebildet und der Isolationsgraben mit mindestens einem Material verfüllt, das eine kleinere elektrische Leitfähigkeit für Ladungsträger des ersten Leitungstyps hat als die Absorberschicht. Erfindungsgemäß wird der Isolationsgraben der mindestens einen Strukturierungszone nach Herstellen der Absorberschicht erzeugt.

Bei einem Dünnschichtsolarmodul in Substratkonfiguration wird für die Herstellung des Schichtenaufbaus zunächst ein flächiges Substrat bereitgestellt und auf einer Seite des Substrats eine Rückelektrodenschicht abgeschieden. Die Rükkelektrodenschicht kann direkt auf eine Oberfläche des Substrats abgeschieden werden. Alternativ kann sich mindestens eine weitere Schicht zwischen Substrat und Rückelektrodenschicht befinden. Über der Rückelektrodenschicht wird eine Absorberschicht abgeschieden. Die Rückelektrodenschicht befindet sich zwischen dem Substrat und der Absorberschicht. Die Absorberschicht kann direkt auf eine Oberfläche der Rückelektrodenschicht abgeschieden werden. Alternativ kann sich mindestens eine weitere Schicht zwischen Rükkelektrodenschicht und Absorberschicht befinden. Über der Absorberschicht wird eine Frontelektrodenschicht abgeschieden. Die Absorberschicht befindet sich zwischen der Frontelektrodenschicht und der Rückelektrodenschicht. Die Frontelektrodenschicht kann direkt auf eine Oberfläche der Absorberschicht abgeschieden werden. Alternativ kann sich mindestens eine weitere Schicht zwischen Frontelektrodenschicht und Absorberschicht befinden. Typischer Weise befindet sich mindestens eine Pufferschicht zwischen Absorberschicht und Frontelektrodenschicht. Mindestens die Rükkelektrodenschicht wird durch erste Strukturierungsgräben P1 strukturiert (unterteilt). Die Strukturierung der Rückelektrodenschicht erfolgt typischer Weise, jedoch nicht zwingend, vor Abscheiden der Absorberschicht. Mindestens die Absorberschicht wird durch zweite Strukturierungsgräben P2 strukturiert (unterteilt). Die Strukturierung der Absorberschicht erfolgt typischer Weise, jedoch nicht zwingend, vor Abscheiden der Frontelektrodenschicht. Mindestens die Frontelektrodenschicht wird durch dritte Strukturierungsgräben P3 strukturiert (unterteilt).

Bei einer vorteilhaften Ausgestaltung des Verfahrens, wird der Isolationsgraben der mindestens einen Strukturierungszone durch Material einer zwischen der Absorberschicht und der Frontelektrodenschicht angeordneten Pufferschicht wenigstens teilweise, insbesondere vollständig, verfüllt. In diesem Fall wird der Isolationsgraben nach Herstellung der Absorberschicht und vor Abscheidung der Pufferschicht in das Material innerhalb des ersten Strukturierungsgrabens eingebracht. Die Verfüllung der Isolationsgräben kann in einfacher Weise in einen bestehenden Prozeß der Dünnschichtsolarmodulherstellung integriert werden, wobei zur Verfüllung der Isolationsgräben in vorteilhafter Weise kein separater Verfahrensschritt erforderlich ist.

Bei einer weiteren Ausgestaltung des Verfahrens, wird der Isolationsgraben der mindestens einen Strukturierungszone durch Material der Frontelektrodenschicht wenigstens teilweise, insbesondere vollständig, verfüllt. In diesem Fall wird der Isolationsgraben nach der Abscheidung der Pufferschicht in das Material innerhalb des ersten Strukturierungsgrabens eingebracht. Die Verfüllung der Isolationsgräben kann in einfacher Weise in einen bestehenden Prozeß der Dünnschichtsolarmodulherstellung integriert werden, wobei zur Verfüllung der Isolationsgräben in vorteilhafter Weise kein separater Verfahrensschritt erforderlich ist.

Bei einer weiteren Ausgestaltung des Verfahrens, wird der Isolationsgraben nach Abscheiden der Frontelektrodenschicht hergestellt und mit einem Material, welches der geforderten Bedingung hinsichtlich der elektrischen Leitfähigkeit des Isolationsgrabenmaterials genügt, verfüllt.

Die Erzeugung eines Isolationsgrabens kann, je nach Verfahrensführung, durch Bestrahlen der Absorberschicht, Pufferschicht oder Frontelektrodenschicht oberhalb eines ersten Strukturierungsgrabens mit einem gepulsten Laserstrahl erfolgen. Die Entfernung von Material zur Erzeugung des Isolationsgrabens kann insbesondere durch eine Veränderung einer oder mehrerer der folgenden Prozeßparameter erreicht werden:
- Laserleistung,
- Verfahrgeschwindigkeit des Laserstrahls relativ zur bestrahlten Oberfläche des Schichtenaufbaus bzw. Substrats,
- Wiederholrate der Laserpulse,
- Pulsdauer,
- Ein- bzw. Ausschaltdauer des Lasers.

Insbesondere kann durch eine räumliche Überlagerung von Laserpulsen die Tiefe des im Schichtenaufbau erzeugten Lochs variiert werden, so dass der Isolationsgraben gezielt herstellbar ist.

Alternativ kann der Isolationsgraben durch eine mechanische Materialabtragung, beispielsweise durch Nadelschreiben, Bürsten oder Schaben, hergestellt werden.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird nun anhand von Ausführungsbeispielen näher erläutert, wobei Bezug auf die beigefügten Zeichnungen genommen wird. Es zeigen in vereinfachter, nicht maßstäblicher Darstellung:
- Fig. 1: eine schematische Darstellung der integrierten Serienverschaltung von Solarzellen eines herkömmlichen Dünnschichtsolarmoduls in einer Schnittansicht;
- Fig. 2: eine schematische Darstellung der integrierten Serienverschaltung von Solarzellen gemäß einer Ausgestaltung des erfindungsgemäßen Dünnschichtsolarmoduls in einer Schnittansicht;
- Fig. 3: eine Variante des Dünnschichtsolarmoduls von Figur 2 in einer Schnittansicht;
- Fig. 4: ein Meßdiagramm, in dem der normalisierte ShuntWiderstand erfindungsgemäßer Dünnschichtsolarmodule gemäß der Ausgestaltung von Figur 2 gezeigt ist;
- Fig. 5: ein Diagramm, in dem der normalisierte ShuntWiderstand erfindungsgemäßer Dünnschichtsolarmodule gemäß der Ausgestaltung von Figur 3 gezeigt ist.

### Ausführliche Beschreibung der Zeichnungen

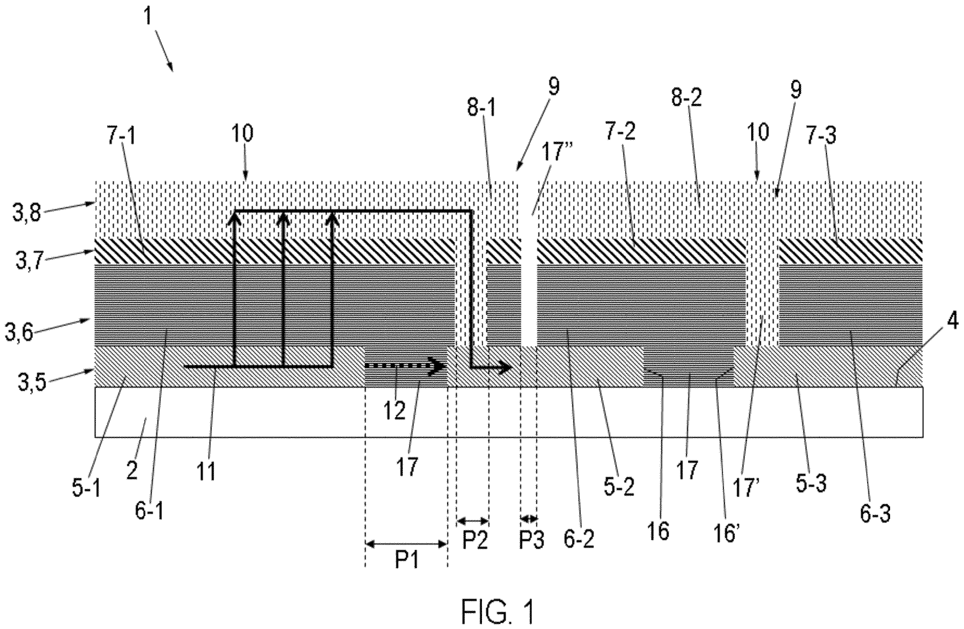

In Figur 1 ist ein insgesamt mit der Bezugszahl 1 bezeichnetes Dünnschichtsolarmodul des Stands der Technik in schematischer Weise anhand einer Querschnittansicht veranschaulicht. Das Dünnschichtsolarmodul 1 umfasst eine Mehrzahl von in integrierter Form seriell miteinander verschalteter Solarzellen 10, wobei in stark vereinfachter Form nur zwei Solarzellen 10 mit identischem Aufbau dargestellt sind. Es versteht sich, dass im Dünnschichtsolarmodul 1 in aller Regel eine Vielzahl von Solarzellen 10 (beispielsweise ca. 100-150) seriell verschaltet sind.

Das Dünnschichtsolarmodul 1 weist hier beispielsweise eine Substratkonfiguration auf, d.h. es verfügt über ein Substrat 2 mit einem darauf aufgebrachten Schichtenaufbau 3 aus dünnen Schichten, wobei der Schichtenaufbau 3 auf einer lichteintrittsseitigen Substratfläche 4 des Substrats 2 angeordnet ist. Das Substrat 2 ist beispielsweise als starre Glasplatte ausgebildet, wobei gleichermaßen andere elektrisch isolierende Materialien mit gewünschter Festigkeit und inertem Verhalten gegenüber den durchgeführten Prozeßschritten eingesetzt werden können.

Der Schichtenaufbau 3 umfasst eine auf der Substratfläche 4 angeordnete opake Rückelektrodenschicht 5, die beispielsweise aus einem lichtundurchlässigen Metall wie Molybdän (Mo) besteht und durch Aufdampfen oder magnetfeldunterstützte Kathodenzerstäubung (Sputtern) auf das Substrat 2 aufgebracht wurde. Die Rückelektrodenschicht 5 hat beispielsweise eine Schichtdicke im Bereich von 300 nm bis 600 nm.

Auf der Rückelektrodenschicht 5 ist eine photovoltaisch aktive Absorberschicht 6 aufgebracht, die aus einem mit Metallionen dotierten Halbleiter besteht, dessen Bandabstand in der Lage ist, einen möglichst großen Anteil des Sonnenlichts zu absorbieren. Die Absorberschicht 6 besteht hier beispielsweise aus einem p-leitenden Chalkopyrit-Verbindungshalbleiter, beispielsweise eine Verbindung der Gruppe Cu(In,Ga)(S,Se)₂, insbesondere Natrium(Na)-dotiertes Cu(In,Ga)(S,Se)₂. In vorstehender Formel können Indium (In) und Gallium (Ga) wahlweise oder in Kombination vorhanden sein. Entsprechendes gilt für Schwefel (S) und Selen (Se), die wahlweise oder in Kombination vorhanden sein können.

Die Absorberschicht 6 hat eine Schichtdicke, die beispielsweise im Bereich von 1-5 µm liegt und insbesondere ca. 2 µm beträgt. Für die Herstellung der Absorberschicht 6 werden verschiedene Materiallagen beispielsweise durch Sputtern aufgebracht, die anschließend durch Erwärmen in einem Ofen, typischer Weise in einer S- und/oder Se-haltigen Atmosphäre, zu dem Verbindungshalbleiter thermisch umgesetzt werden (RTP = Rapid Thermal Processing). Dem Fachmann ist diese Art der Herstellung eines Verbindungshalbleiters geläufig, so dass hier nicht näher darauf eingegangen werden muss.

Auf die Absorberschicht 6 ist eine Pufferschicht 7 abgeschieden, die hier beispielsweise aus einer Einzellage aus mit Natrium dotiertem Indiumsulfid (In₂S₃:Na) und einer Einzellage aus (nichtdotiertem) intrinsischem Zinkoxid (i-ZnO) besteht, was in Figur 1 nicht näher dargestellt ist.

Auf die Pufferschicht 7 ist eine Frontelektrodenschicht 8 beispielsweise durch Sputtern aufgebracht. Die Frontelektrodenschicht 8 ist für Strahlung im sichtbaren Spektralbereich transparent ("Fensterelektrode"), so dass einstrahlendes Sonnenlicht nur gering geschwächt wird. Die Frontelektrodenschicht 8 basiert beispielsweise auf einem dotierten Metalloxid, beispielsweise n-leitendes Aluminium (Al)-dotiertes Zinkoxid (ZnO). Eine solche Frontelektrodenschicht 8 wird allgemein als TCO-Schicht (TCO = Transparent Conductive Oxide) bezeichnet. Die Schichtdicke der Frontelektrodenschicht 8 beträgt beispielsweise ca. 500 nm. Die Frontelektrodenschicht 8, Pufferschicht 7 und Absorberschicht 6 formen gemeinsam einen Heteroübergang (p-n-Übergang). Durch die Pufferschicht 7 wird eine elektronische Anpassung zwischen der Absorberschicht 6 und der Frontelektrodenschicht 8 bewirkt.

Der Schichtenaufbau 3 weist verschiedene Strukturierungsgräben auf, wodurch die serienverschalteten Solarzellen 10 geformt werden. Die Strukturierung kann unter Anwendung einer geeigneten Strukturierungstechnologie, beispielsweise Laserschreiben und/oder mechanische Abtragung, erfolgen. So wird durch erste Strukturierungsgräben P1 die Rückelektrodenschicht 5 in voneinander getrennte Rückelektrodenschichtabschnitte unterteilt, welche die Rückelektroden 5-1, 5-2, 5-3 der Solarzellen 10 bilden. Durch zweite Strukturierungsgräben P2 wird die Absorberschicht 6 in voneinander getrennte Absorberschichtabschnitte unterteilt, die jeweils die photovoltaisch aktiven Bereiche beziehungsweise Absorber 6-1, 6-2, 6-3 der Solarzellen 10 bilden. Die zweiten Strukturierungsgräben P2 unterteilen zudem die Pufferschicht 7 in voneinander getrennte Pufferschichtabschnitte, welche die Puffer 7-1, 7-2, 7-3 der Solarzellen 10 bilden. Durch dritte Strukturierungsgräben P3 wird Frontelektrodenschicht 8 in voneinander getrennte Frontelektrodenschichtabschnitte unterteilt, die jeweils die Frontelektroden 8-1, 8-2 der Solarzellen 10 bilden. Die dritten Strukturierungsgräben P3 erstrecken sich hier beispielsweise bis zur Rückelektrodenschicht 5. Jede unmittelbare Abfolge aus erstem, zweitem und drittem Strukturierungsgraben P1-P2-P3 bildet eine Strukturierungszone 9. Eine einzelne Solarzelle 10 ist durch zwei benachbarte Strukturierungszonen 9 definiert.

Der erste Strukturierungsgraben P1 wird durch die von den angrenzenden Rückelektroden 5-1, 5-2 geformten Strukturierungsgrabenwänden 16, 16' begrenzt, wobei der Bereich zwischen den beiden Strukturierungsgrabenwänden 16, 16' durch ein Strukturierungsgrabenmaterial 17 der Absorberschicht 6 verfüllt ist. Das Strukturierungsgrabenmaterial 17 ist ein substratseitiger Abschnitt der Absorberschicht 6. Der zweite Strukturierungsgraben P2 ist durch ein Strukturierungsmaterial 17' der Frontelektrodenschicht 8 verfüllt, so dass die Frontelektrode 8-1 einer Solarzelle 10 mit der Rückelektrode 5-2 der angrenzenden Solarzelle 10 elektrisch leitend verbunden ist, wobei die Frontelektrode 8-1 die Rückelektrode 5-2 durch das Strukturierungsgrabenmaterial 17' direkt kontaktiert. Das Strukturierungsgrabenmaterial 17' ist substratseitiger Abschnitt der Frontelektrodenschicht 8. Hierdurch werden die Solarzellen 10 in integrierter Form serienverschaltet. Der dritte Strukturierungsgraben P3 ist durch ein Strukturierungsgrabenmaterial 17" einer Klebeschicht verfüllt, welche dazu dient, zum Schutz vor Umwelteinflüssen das beschichtete Substrat 2 mit einer Deckschicht (z.B. Glasplatte) zu verbinden. Dies ist in Figur 1 nicht gezeigt und für das Verständnis der Erfindung ohne Belang.

Bei Sonneneinstrahlung werden in den photovoltaisch aktiven Absorbern 6-1, 6-2, 6-3 der Solarzellen 10 Elektronen-Loch-Paare erzeugt. In der p-leitenden Absorberschicht 6 und n-leitenden Frontelektrodenschicht 8 bildet sich eine Raumladungszone aus, deren elektrisches Feld bewirkt, dass die photovoltaisch erzeugten Elektronen zu den Frontelektroden 8-1, 8-2 und die Löcher zu den Rückelektroden 5-1, 5-2, 5-3 driften. Ein resultierender Strompfad 11 ist in Figur 1 in schematischer Weise veranschaulicht.

Das im ersten Strukturierungsgraben P1 befindliche Strukturierungsmaterial 17 der Absorberschicht 6 bildet einen Kurzschlußpfad (Shuntpfad) 12 für die zu den Rückelektroden 5-1, 5-2, 5-3 driftenden Löcher. Ursache hierfür ist die nicht zu vernachlässigende elektrische Leitfähigkeit für Löcher des Strukturierungsmaterials 17 im ersten Strukturierungsgraben P1. Der Kurzschlußpfad 12 ist in Figur 1 durch einen gestrichelten Pfeil schematisch veranschaulicht. Über den Kurzschlußpfad 12 können die zur Rückelektrode 5-1 driftenden Löcher zur angrenzenden Rückelektrode 5-2 geleitet werden. Wie die Erfinder erkannt haben, wird durch diesen permanenten Kurzschlußpfad 12 in nachteiliger Weise der Füllfaktor des Dünnschichtsolarmoduls 1 verringert.

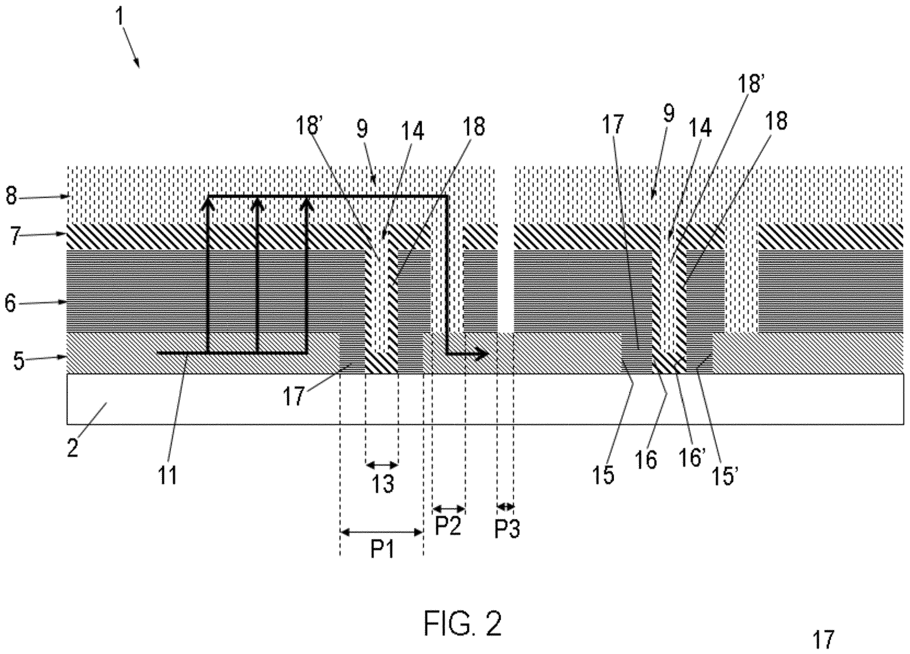

Es wird nun Bezug auf Figur 2 genommen, worin eine Ausgestaltung des erfindungsgemäßen Dünnschichtsolarmoduls 1 veranschaulicht ist. Um unnötige Wiederholungen zu vermeiden, werden lediglich die Unterschiede zu Figur 1 erläutert und ansonsten wird auf die dortigen Ausführungen Bezug genommen. Demnach ist im Schichtenaufbau 3 im Bereich des ersten Strukturierungsgrabens P1 ein mit Material verfüllter Isolationsgraben 13 geformt. Der Isolationsgraben 13 ist in der Absorberschicht 6 und im Strukturierungsgrabenmaterial 17 des ersten Strukturierungsgrabens P1 ausgebildet, wobei sich der Isolationsgraben 13 bis zum Boden des ersten Strukturierungsgrabens P1 erstreckt. Der Isolationsgraben 13 weist einander gegenüberliegende Isolationsgrabenwände 16, 16' auf, die über die komplette Erstreckung des Isolationsgrabens 13 von dem Material der Absorberschicht 6 gebildet werden.

Der Isolationsgraben 13 wurde nach Herstellung der Absorberschicht 6 und vor Abscheidung der Pufferschicht 7 hergestellt. Mit Abscheiden der Pufferschicht 7 wurde der Isolationsgraben 13 durch Isolationsgrabenmaterial 18 der Pufferschicht 7 teilweise verfüllt, wobei verfahrensbedingt ein Restgraben 14 verblieb, der beim Abscheiden der Frontelektrodenschicht 8 mit Isolationsgrabenmaterial 18' der Frontelektrodenschicht 8 verfüllt wurde. Wie in Figur 2 gezeigt, ist der Isolationsgraben 13 nach Abscheiden der Frontelektrodenschicht 8 vollständig verfüllt mit Isolationsgrabenmaterial 18 der Pufferschicht 7 und Isolationsgrabenmaterial 18' der Frontelektrodenschicht 8.

Der Isolationsgraben 13 hat eine mittige Position innerhalb des ersten Strukturierungsgrabens P1, wobei die zwischen den Isolationsgrabenwänden 16, 16' sich bemessende Breite des Isolationsgrabens 13 in etwa einem Drittel der sich zwischen den Strukturierungsgrabenwänden 15, 15' sich bemessenden Breite des ersten Strukturierungsgrabens P1 entspricht.

Der Isolationsgraben 13 ist teilweise mit Material der Pufferschicht 7 und teilweise mit Material der n-leitenden Frontelektrodenschicht 8 gefüllt. Sowohl das Material der Pufferschicht 7 als auch das Material der Frontelektrodenschicht 8 weist einen relativ hohen elektrischen Widerstand für Löcher auf. Hierdurch kann eine elektrische Kurzschlußleitung von Löchern zwischen den angrenzenden Rückelektroden 5-1, 5-2 des ersten Strukturierungsgrabens P1 entsprechend dem in Figur 1 schematisch dargestellten Kurzschlußpfad 12 sehr gut gehemmt werden, wodurch der Füllfaktor und damit der Wirkungsgrad des Dünnschichtsolarmoduls 1 verbessert wird.

In Figur 2 hat der Isolationsgraben 13 eine mittige Position innerhalb des ersten Strukturierungsgrabens P1, wobei es vorteilhaft sein kann, den Isolationsgraben 13 in Richtung des zweiten Strukturierungsgrabens P2 zu versetzen, so dass sich die Mitte des Isolationsgrabens 13 innerhalb der dem zweiten Strukturierungsgraben P2 näheren Hälfte des ersten Strukturierungsgrabens P1 befindet. Denkbar wäre, den Isolationsgraben 13 so weit in diese Richtung zu versetzen, dass die Rückelektrode 5-2 die Isolationsgrabenwand 16' bildet. Diese Ausgestaltung kann verfahrenstechnische Vorteile haben, besonders wenn der Isolationsgraben 13 relativ breit ist, da ein Berührungskontakt des Isolationsgrabenmaterials 18 mit der gegenüberliegenden Rückelektrode 5-1 zuverlässig und sicher verhindert wird.

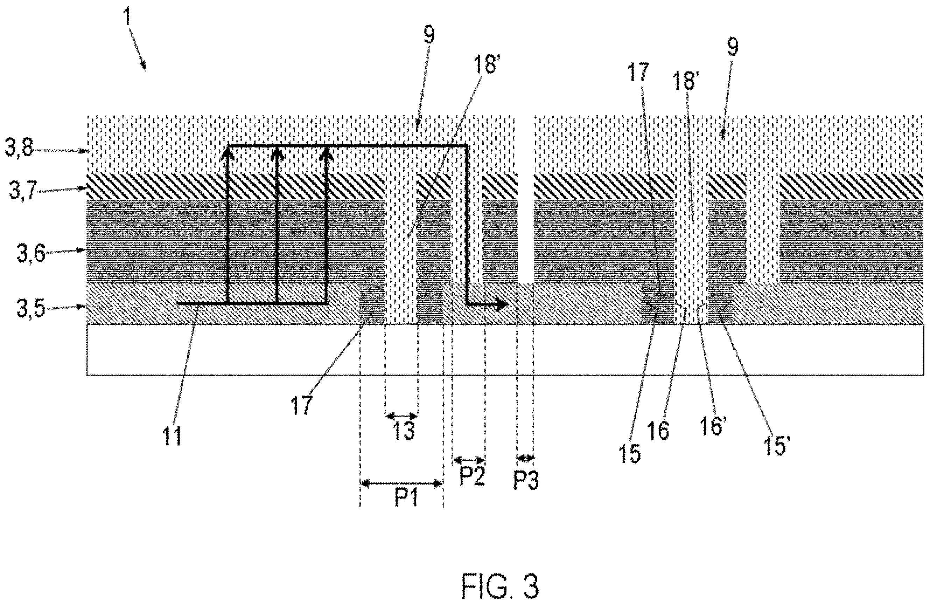

In Figur 3 ist eine weitere Ausgestaltung des erfindungsgemäßen Dünnschichtsolarmoduls 1 veranschaulicht. Es werden wiederum nur die Unterschiede zu Figur 1 und 2 beschrieben und ansonsten wird auf die dortigen Ausführungen Bezug genommen.

Bei dieser Ausgestaltung wurde der Isolationsgraben 13 nach Abscheidung der Pufferschicht 7 hergestellt und mit Isolationsgrabenmaterial 18' der Frontelektrodenschicht 8 vollständig verfüllt. Der Isolationsgraben ist in der Pufferschicht 7, der Absorberschicht 6 und im Strukturierungsgrabenmaterial 17 des ersten Strukturierungsgrabens P1 ausgebildet, wobei sich der Isolationsgraben 13 bis zum Boden des ersten Strukturierungsgrabens P1 erstreckt. Der Isolationsgraben 13 weist einander gegenüberliegende Isolationsgrabenwände 16, 16' auf, die von Material der Pufferschicht 7 und Material der Absorberschicht 6 gebildet werden.

Auch durch den mit Isolationsgrabenmaterial 18' der Frontelektrodenschicht verfüllten Isolationsgraben 13 kann eine elektrische Kurzschlußleitung von Löchern zwischen den angrenzenden Rückelektroden 5-1, 5-2 des ersten Strukturierungsgrabens P1 entsprechend dem in Figur 1 schematisch dargestellten Kurzschlußpfad 12 sehr gut gehemmt werden, wodurch der Füllfaktor und damit Wirkungsgrad des Dünnschichtsolarmoduls 1 erhöht wird.

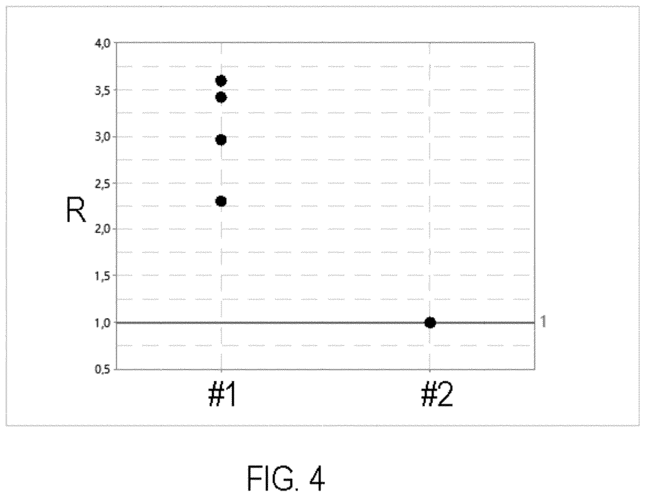

In Figur 4 ist ein Meßdiagramm gezeigt, in dem der normalisierte elektrische Shunt-Widerstand (R) von erfindungsgemäßen Dünnschichtsolarmodulen (#1), welche gemäß Figur 2 mit Isolationsgrabenmaterial 18 der Pufferschicht 7 und Isolationsgrabenmaterial 18' der Frontelektrodenschicht 8 gefüllten Isolationsgräben 13 versehen waren, und für ein vergleichbares Referenzmodul (#2) ohne Isolationsgräben aufgetragen ist. Die Normalisierung der Meßwerte erfolgte in Bezug auf den Shunt-Widerstand für das Referenzmodul (#2). Demnach konnte durch die Isolationsgräben 13 innerhalb der ersten Strukturierungsgräben P1 eine relative Erhöhung des Shunt-Widerstands (R) wenigstens um einen Faktor 2,25 erreicht werden. Die Meßwerte für den Shunt-Widerstand der erfindungsgemäßen Dünnschichtsolarmodule lagen innerhalb eines Bereichs des 2,25-fachen bis 3,6-fachen des Vergleichswerts für das Referenzmodul.

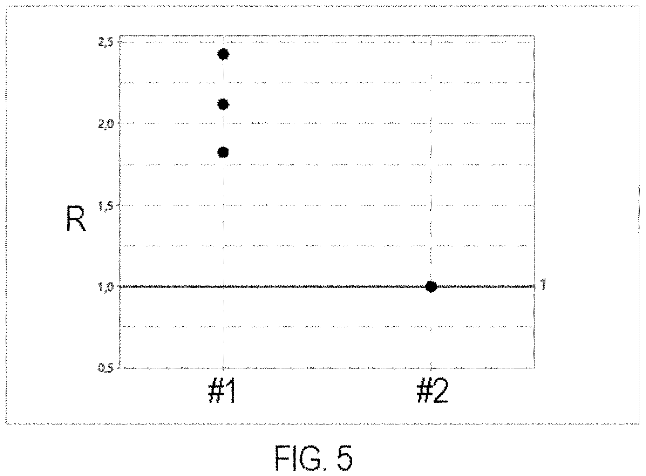

In Figur 5 ist ein weiteres Meßdiagramm gezeigt, in dem der normalisierte elektrische Shunt-Widerstand (R) von erfindungsgemäßen Dünnschichtsolarmodulen (#1), welche gemäß Figur 3 mit Isolationsgrabenmaterial 18' der Frontelektrodenschicht 8 gefüllten Isolationsgräben 13 versehen waren, und für ein vergleichbares Referenzmodul (#2) ohne Isolationsgräben aufgetragen ist. Die Normalisierung der Meßwerte erfolgte in Bezug auf den Shunt-Widerstand für das Referenzmodul (#2). Demnach konnte durch die Isolationsgräben 13 innerhalb der ersten Strukturierungsgräben P1 eine relative Erhöhung des Shunt-Widerstands (R) wenigstens um einen Faktor 1,75 erreicht werden. Die Meßwerte für den Shunt-Widerstand der erfindungsgemäßen Dünnschichtsolarmodule lagen innerhalb eines Bereichs des 1,75-fachen bis 2,5-fachen des Vergleichswerts für das Referenzmodul.

Die Erfindung stellt ein Dünnschichtsolarmodul zur Verfügung, durch das mittels Isolationsgräben innerhalb der mit Material der Absorptionsschicht gefüllten ersten Strukturierungsgräben in vorteilhafter Weise eine Verringerung der elektrischen Leitfähigkeit bzw. Erhöhung des elektrischen Widerstands (Shunt-Widerstand) für die Überschuß-Ladungsträger der Absorptionsschicht erreicht wird. Aufgrund des erhöhten Shunt-Widerstands und eines damit verringerten Shunt-Stroms kann der Füllfaktor und somit der Wirkungsgrad des Dünnschichtsolarmoduls erheblich verbessert werden. Wie aus vorstehender Beschreibung hervorgeht, kann die Fertigung der Isolationsgräben in einfacher und kostengünstiger Weise in den Fertigungsprozeß herkömmlicher Dünnschichtsolarmodule integriert werden.

### Bezugszeichenliste

1 Dünnschichtsolarmodul
2 Substrat
3 Schichtenaufbau
4 Substratfläche
5 Rückelektrodenschicht
5-1, 5-2, 5-3 Rückelektrode
6 Absorberschicht
6-1,6-2,6-3 Absorber
7 Pufferschicht
7-1, 7-2, 7-3 Puffer
8 Frontelektrodenschicht
8-1,8-2 Frontelektrode
9 Strukturierungszone
10 Solarzelle
11 Strompfad
12 Kurzschlußpfad (Shuntpfad)
13 Isolationsgraben
14 Restgraben
15, 15' Strukturierungsgrabenwand
16, 16' Isolationsgrabenwand
17, 17', 17" Strukturierungsgrabenmaterial
18, 18' Isolationsgrabenmaterial

## Patentansprüche

1. Dünnschichtsolarmodul (1) mit einem Substrat (2) und einem darauf aufgebrachten Schichtenaufbau (3), der eine Rückelektrodenschicht (5), eine Frontelektrodenschicht (8) und eine zwischen Rück- und Frontelektrodenschicht angeordnete Absorberschicht (6) umfasst, wobei die Absorberschicht (6) eine Dotierung von einem ersten Leitungstyp und die Frontelektrodenschicht (8) eine Dotierung vom zweiten Leitungstyp aufweist, wobei im Schichtenaufbau (3) durch Strukturierungszonen (9) serienverschaltete Solarzellen (10) ausgebildet sind, wobei mindestens eine Strukturierungszone (9) aufweist:
- einen mindestens die Rückelektrodenschicht (5) unterteilenden ersten Strukturierungsgraben (P1),
- einen mindestens die Absorberschicht (6) unterteilenden zweiten Strukturierungsgraben (P2),
- einen mindestens die Frontelektrodenschicht (8) unterteilenden dritten Strukturierungsgraben (P3),
wobei der erste Strukturierungsgraben (P1) durch Material der Absorberschicht (6) verfüllt ist, und wobei innerhalb des ersten Strukturierungsgrabens (P1) mindestens ein Isolationsgraben (13) ausgebildet ist, der durch mindestens ein Material verfüllt ist, das eine kleinere elektrische Leitfähigkeit für Ladungsträger vom ersten Leitungstyp aufweist als die Absorberschicht (6).

2. Dünnschichtsolarmodul (1) nach Anspruch 1, bei welchem zwischen der Absorberschicht (6) und der Frontelektrodenschicht (8) eine Pufferschicht (7) angeordnet ist, wobei der Isolationsgraben (13) wenigstens teilweise durch Material der Pufferschicht (7) verfüllt ist.

3. Dünnschichtsolarmodul (1) nach Anspruch 2, bei welchem das Material der Pufferschicht (7) eine oder mehrere Verbindungen aufweist, gewählt aus der Gruppe, bestehend aus Indiumsulfid (InS), Natrium-dotiertes Indiumsulfid (InS:Na), Kadmiumsulfid (CdS), Zinkoxosulfid (ZnOS) und intrinsisches Zinkoxid (i-ZnO).

4. Dünnschichtsolarmodul (1) nach Anspruch 1, bei welchem der Isolationsgraben (13) wenigstens teilweise mit einem Material verfüllt ist, das eine Dotierung vom zweiten Ladungsträgertyp aufweist.

5. Dünnschichtsolarmodul (1) nach Anspruch 4, bei welchem der Isolationsgraben (13) durch Material der Frontelektrodenschicht (8), insbesondere Aluminium-dotiertes Zinkoxid (ZnO:Al), verfüllt ist.

6. Dünnschichtsolarmodul (1) nach einem der Ansprüche 1 bis 5, bei welchem der Isolationsgraben (13) innerhalb des den ersten Strukturierungsgraben (P1) verfüllenden Materials der Absorberschicht (6) ausgebildet ist, wobei einander gegenüberliegende Grabenwände (16, 16') des Isolationsgrabens (13) zumindest innerhalb des ersten Strukturierungsgrabens (P1) durch Material der Absorberschicht (6) gebildet sind.

7. Dünnschichtsolarmodul (1) nach einem der Ansprüche 1 bis 5, bei welchem der Isolationsgraben (13) an einem Rand (15') des ersten Strukturierungsgrabens (P1) angeordnet ist, wobei der Rand (15') näher zum zweiten Strukturierungsgraben (P2) der Strukturierungszone (9) angeordnet ist als ein gegenüberliegender Rand (15) des ersten Strukturierungsgrabens (P1).

8. Dünnschichtsolarmodul (1) nach einem der Ansprüche 1 bis 7, bei welchem die Mitte einer Abmessung (B) des Isolationsgrabens (13), bemessen in Richtung der Abfolge des ersten, zweiten und dritten Strukturierungsgrabens (P1-P3) der Strukturierungszone (9) relativ zur Mitte einer Abmessung des ersten Strukturierungsgrabens (P1), bemessen in Richtung der Abfolge des ersten, zweiten und dritten Strukturierungsgrabens (P1-P3) der Strukturierungszone (9), in Richtung des zweiten Strukturierungsgrabens (P2) versetzt ist.

9. Dünnschichtsolarmodul (1) nach einem der Ansprüche 1 bis 8, bei welchem der Isolationsgraben (13) das Material der Absorberschicht (6) innerhalb des ersten Strukturierungsgrabens (P1) vollständig unterteilt oder vom Rand (15') der ersten Strukturierungszone (P1) vollständig abtrennt.

10. Dünnschichtsolarmodul (1) nach einem der Ansprüche 1 bis 9, bei welchem der Isolationsgraben (13) eine solche in Richtung der Abfolge des ersten, zweiten und dritten Strukturierungsgrabens (P1-P3) sich bemessende Breite (B) aufweist, dass ein elektrischer Widerstand für Ladungsträger vom ersten Leitungstyp im ersten Strukturierungsgraben mindestens das 1,5-fache, insbesondere mindestens das 2-fache, insbesondere das 1,5-fache bis 4-fache, des elektrischen Widerstands für Ladungsträger vom ersten Leitungstyp im Strukturierungsgraben ohne Isolationsgraben beträgt.

11. Dünnschichtsolarmodul (1) nach einem der Ansprüche 1 bis 9, bei welchem der Isolationsgraben (13) eine in Richtung der Abfolge des ersten, zweiten und dritten Strukturierungsgrabens (13) sich bemessende Breite (B) aufweist, die mindestens 10%, insbesondere mindestens 20%, der Breite des ersten Strukturierungsgrabens (P1) beträgt.

12. Verfahren zur Herstellung eines Dünnschichtsolarmoduls (1) nach einem der Ansprüche 1 bis 11, welches die folgenden Schritte umfasst:
- Bereitstellen eines Substrats (2),
- Herstellen eines eine Rückelektrodenschicht (5), eine Frontelektrodenschicht (8) und eine zwischen Rück- und Frontelektrodenschicht angeordnete Absorberschicht (6) aufweisenden Schichtenaufbaus (3) mit durch Strukturierungszonen (9) serienverschalteten Solarzellen (10) auf dem Substrat (2), wobei die Absorberschicht (6) eine Dotierung von einem ersten Leitungstyp und die Frontelektrodenschicht (8) eine Dotierung vom zweiten Leitungstyp aufweist, wobei die Strukturierungszonen (9) jeweils erste Strukturierungsgräben (P1) zur Unterteilung der Rückelektrodenschicht (5) aufweisen, die durch Material der Absorberschicht (6) verfüllt sind, wobei mindestens ein Isolationsgraben (13) innerhalb eines die Rückelektrodenschicht (5) unterteilenden ersten Strukturierungsgrabens (P1) mindestens einer Strukturierungszone (9) ausgebildet und der Isolationsgraben (13) mit einem Material, das eine kleinere elektrische Leitfähigkeit für Ladungsträger des ersten Leitungstyps hat als die Absorberschicht (6), verfüllt ist.

13. Verfahren nach Anspruch 12, bei welchem der Isolationsgraben (13) durch Material einer zwischen der Absorberschicht (6) und der Frontelektrodenschicht (8) angeordneten Pufferschicht (7) verfüllt wird.

14. Verfahren nach Anspruch 12, bei welchem der Isolationsgraben (13) durch Material der Frontelektrodenschicht (8) verfüllt wird.

15. Verfahren nach Anspruch 12, bei welchem der Isolationsgraben (13) nach Abscheiden der Frontelektrodenschicht (8) hergestellt und verfüllt wird.
